# EUROPEAN PATENT APPLICATION

(11) **EP 4 539 630 A1**
(43) Date of publication of application: **16.04.2025**
(21) Application number: 24200976.9
(22) Date of filing: 18.09.2024
(51) Int. Cl.: H10D 30/67, H10D 64/62

(54) **SEMICONDUCTOR DEVICE**

(30) Priority: 29.09.2023 JP 2023169696
(71) Applicant: Japan Display Inc., Tokyo 105-0003 (JP)
(72) Inventor: WATAKABE, Hajime, Tokyo, 105-0003 (JP); TSUBUKU, Masashi, Tokyo, 105-0003 (JP); MIURA, Kentaro, Tokyo, 105-0003 (JP); WATABE, Masahiro, Tokyo, 105-0003 (JP)
(74) Representative: MERH-IP Matias Erny Reichl Hoffmann Patentanwälte PartG mbB

(57) **Abstract**

A semiconductor device according to an embodiment of the present invention includes: an oxide semiconductor layer; a first gate electrode facing the oxide semiconductor layer; a first gate insulating layer between the oxide semiconductor layer and the first gate electrode; an electrode arranged in a region overlapping the oxide semiconductor layer in a plan view and electrically connected to the oxide semiconductor layer; and a metal nitride layer between the oxide semiconductor layer and the electrode, wherein the oxide semiconductor layer is polycrystalline, and an etching rate of the oxide semiconductor layer with respect to an etchant containing phosphoric acid as a main component is less than 3 nm/min at 40°C.

## Description

### TECHNICAL FIELD

An embodiment of the present invention relates to a semiconductor device.

### BACKGROUND ART

In recent years, instead of amorphous silicon, low-temperature polysilicon, and single-crystal silicon, a semiconductor device in which an oxide semiconductor is used for a channel has been developed (for example, Patent Literature 1 to 6. The semiconductor device in which an oxide semiconductor is used for a channel has a simple structure and is formed by a low-temperature process, similar to the semiconductor device in which amorphous silicon is used for a channel. The semiconductor device in which an oxide semiconductor is used for a channel is known to have higher mobility than the semiconductor device in which amorphous silicon is used for a channel.

It is essential to provide oxygen to an oxide semiconductor layer and reduce oxygen vacancies formed in the oxide semiconductor layer in a manufacturing process in order for the semiconductor device in which an oxide semiconductor is used for a channel to operate stably. For example, a technique in which an insulating layer covering an oxide semiconductor layer is formed under a condition that the insulating layer contains more oxygen is disclosed as one of the methods of supplying oxygen to the oxide semiconductor layer.

### CITATION LIST

### PATENT LITERATURE

Patent Literature 1: Japanese laid-open patent publication No. 2021-141338
Patent Literature 2: Japanese laid-open patent publication No. 2014-099601
Patent Literature 3: Japanese laid-open patent publication No. 2021-153196
Patent Literature 4: Japanese laid-open patent publication No. 2018-006730
Patent Literature 5: Japanese laid-open patent publication No. 2016-184771
Patent Literature 6: Japanese laid-open patent publication No. 2021-108405

### SUMMARY OF INVENTION

### TECHNICAL PROBLEM

By a heat treatment in a manufacturing process (for example, a heat treatment for supplying oxygen contained in an insulating layer to an oxide semiconductor layer), a conductive layer contacting an oxide semiconductor layer may react with the oxide semiconductor layer. Due to this reaction, the electrical characteristics of the semiconductor device in which the oxide semiconductor layer is used deteriorate (the on-state current decreases). The above problem has been confirmed to occur in a reliability test (stress test) of the semiconductor device, and is a factor that reduces the reliability of the semiconductor device.

An object of an embodiment of the present invention is to provide a semiconductor device with high mobility and reliability.

### SOLUTION TO PROBLEMS

A semiconductor device according to an embodiment of the present invention includes: an oxide semiconductor layer; a first gate electrode facing the oxide semiconductor layer; a first gate insulating layer between the oxide semiconductor layer and the first gate electrode; an electrode arranged in a region overlapping the oxide semiconductor layer in a plan view and electrically connected to the oxide semiconductor layer; and/or a metal nitride layer between the oxide semiconductor layer and the electrode, wherein the oxide semiconductor layer is polycrystalline, and an etching rate of the oxide semiconductor layer with respect to an etchant containing phosphoric acid as a main component is less than 3 nm/min at 40°C. Further the content of JP2023-169696 from which priority is claimed for the present application shall be introduced herein fully by way of reference.

### BRIEF DESCRIPTION OF DRAWINGS

FIG. 1 is a plan view illustrating a semiconductor device according to an embodiment of the present invention.
FIG. 2 is a cross-sectional view illustrating a semiconductor device according to an embodiment of the present invention.
FIG. 3 is a cross-sectional view illustrating a method for manufacturing a semiconductor device according to an embodiment of the present invention.
FIG. 4 is a cross-sectional view illustrating a method for manufacturing a semiconductor device according to an embodiment of the present invention.
FIG. 5 is a cross-sectional view illustrating a method for manufacturing a semiconductor device according to an embodiment of the present invention.
FIG. 6 is a cross-sectional view illustrating a method for manufacturing a semiconductor device according to an embodiment of the present invention.
FIG. 7 is a cross-sectional view illustrating a semiconductor device according to an embodiment of the present invention.
FIG. 8 is a cross-sectional view illustrating a method for manufacturing a semiconductor device according to an embodiment of the present invention.
FIG. 9 is a cross-sectional view illustrating a method for manufacturing a semiconductor device according to an embodiment of the present invention.
FIG. 10 is a cross-sectional view illustrating a method for manufacturing a semiconductor device according to an embodiment of the present invention.
FIG. 11 is a cross-sectional view illustrating a semiconductor device according to an embodiment of the present invention.
FIG. 12 is a cross-sectional view illustrating a method for manufacturing a semiconductor device according to an embodiment of the present invention.
FIG. 13 is a cross-sectional view illustrating a method for manufacturing a semiconductor device according to an embodiment of the present invention.
FIG. 14 is a cross-sectional view illustrating a method for manufacturing a semiconductor device according to an embodiment of the present invention.
FIG. 15 is a cross-sectional view illustrating a semiconductor device according to an embodiment of the present invention.

### DESCRIPTION OF EMBODIMENTS

Hereinafter, embodiments of the present invention will be described with reference to the drawings. The following disclosure is merely an example. A configuration that can be easily conceived by a person skilled in the art by appropriately changing the configuration of the embodiment while keeping the gist of the invention is naturally included in the scope of the present invention. For clarity of explanation, the drawings may be schematically represented with respect to widths, thicknesses, shapes, and the like of respective portions as compared with actual embodiments. However, the illustrated shapes are merely examples, and do not limit the interpretation of the present invention. In the present specification and the drawings, the same reference signs are given to the same components as those described above with respect to the above-described drawings, and detailed description thereof may be omitted as appropriate.

In the embodiments of the present invention, a direction from a substrate toward an oxide semiconductor layer is referred to as upper or above. Conversely, a direction from the oxide semiconductor layer to the substrate is referred to as lower or below. In this way, for convenience of explanation, the phrase "above" or "below" is used for explanation, but for example, the vertical relationship between the substrate and the oxide semiconductor layer may be different from that shown in the drawings. In the following explanation, for example, the expression "oxide semiconductor layer on a substrate" merely describes the vertical relationship between the substrate and the oxide semiconductor layer as described above, and another member may be arranged between the substrate and the oxide semiconductor layer. The "above" or "below" means a stacking order in a structure in which a plurality of layers is stacked, and when expressed as a pixel electrode above a transistor, it may be a positional relationship in which the transistor and the pixel electrode do not overlap in a plan view. On the other hand, when expressed as a pixel electrode vertically above a transistor, it means a positional relationship in which the transistor and the pixel electrode overlap in a plan view.

In the present specification, the terms "film" and "layer" can optionally be interchanged with one another.

"Display device" refers to a structure that displays an image using an electro-optic layer. For example, the term "display device" may refer to a display panel that includes the electro-optic layer, or may refer to a structure with other optical members (for example, a polarized member, a backlight, a touch panel, and the like) attached to a display cell. "Electro-optical layer" may include a liquid crystal layer, an electroluminescent (EL) layer, an electrochromic (EC) layer, or an electrophoretic layer, as long as no technical contradiction is caused. Therefore, although a display device will be described by exemplifying a liquid crystal display device including a liquid crystal layer and an organic EL display device including an organic EL layer for the embodiments described later, the structure according to the present embodiment can be applied to a display device including other electro-optical layers described above.

In the present specification, the expressions "α includes A, B, or C," "α includes any of A, B, and C," and "α includes one selected from a group consisting of A, B, and C," do not exclude the case where α includes a plurality of combinations of A to C unless otherwise specified. Furthermore, these expressions do not exclude the case where α includes other elements.

The following embodiments can be combined with each other as long as there is no technical contradiction.

### [1. First Embodiment]

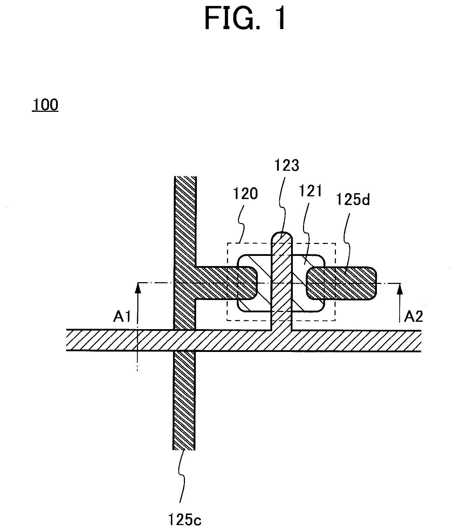

An example of a structure of a semiconductor device 100 according to an embodiment of the present invention will be described with reference to FIG. 1 to FIG. 6.

### [1-1. Configuration of Semiconductor Device]

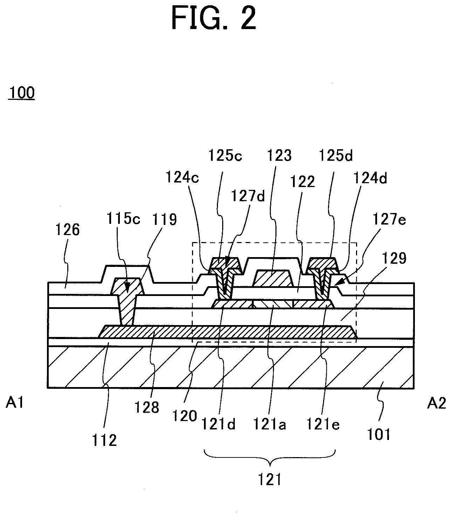

FIG. 1 is a plan view of the semiconductor device 100 according to an embodiment of the present invention. FIG. 2 is a cross-sectional view when the semiconductor device 100 shown in FIG. 1 is cut along a line A1-A2. As shown in FIG. 1 and FIG. 2, the semiconductor device 100 according to an embodiment of the present invention includes a transistor 120 arranged on a substrate 101.

As shown in FIG. 2, an insulating layer 112 is arranged on the substrate 101. The transistor 120 is arranged on the insulating layer 112. The transistor 120 includes an oxide semiconductor layer 121, gate insulating layers 122 and 129, and gate electrodes 123 and 128. An interlayer insulating layer 126 is arranged on the gate electrode 123. Although details will be described later, the oxide semiconductor layer 121 is polycrystalline.

The gate electrode 128 is arranged between the insulating layer 112 and the gate insulating layer 129. The gate electrode 128 is arranged in a region that overlaps the oxide semiconductor layer 121 (in particular, a channel region 121a) in a plan view. A wiring 119 is arranged on the gate insulating layers 122 and 129. The wiring 119 is connected to the gate electrode 128 via an opening 115c arranged in each of the gate insulating layers 122 and 129. The wiring 119 is in the same layer as the gate electrode 123 and in a different layer from a source electrode 125c and a drain electrode 125d. In other words, the wiring 119 is in contact with an upper surface of the gate insulating layer 122, while the source electrode 125c and the drain electrode 125d are in contact with an upper surface of the interlayer insulating layer 126, which will be described later.

The channel region 121a, a source region 121d, and a drain region 121e are arranged in the oxide semiconductor layer 121. The source region 121d and the drain region 121e are adjacent to the channel region 121a. In a plan view, the channel region 121a overlaps the gate electrode 123.

The oxide semiconductor layer 121 of the channel region 121a has semiconducting properties. That is, depending on a voltage applied to the gate electrodes 123 and 128, the oxide semiconductor layer 121 of the channel region 121a is switched between a state functioning as a current path and a state not functioning as a current path. The carrier concentration in the oxide semiconductor layer 121 in the source region 121d and the drain region 121e is greater than the carrier concentration in the oxide semiconductor layer 121 in the channel region 121a.

For example, the sheet resistance of the oxide semiconductor layer 121 in the source region 121d and the drain region 121e is 1000 Ω/sq. or less, preferably 500 Ω/sq. or less, and more preferably 250 Ω/sq. or less. In other words, the oxide semiconductor layer 121 in the channel region 121a has a higher electrical resistance (or lower electrical conductivity) than the oxide semiconductor layer 121 in each of the source region 121d and the drain region 121e.

Referring to FIG. 1, a region of the oxide semiconductor layer 121 that overlaps the gate electrode 123 is the channel region 121a, and a region that does not overlap the gate electrode 123 (a region exposed from the gate electrode 123) is the source region 121d and the drain region 121e. A direction in which a line connecting A1 and A2 in FIG. 1 extends is a channel length direction. A direction orthogonal to the channel length direction is a channel width direction. In other words, the channel length direction is an extension direction of the shortest distance of a line connecting any one point in the source region 121d to the drain region 121e.

A voltage for controlling the channel region 121a is supplied to the gate electrodes 123 and 128, respectively. That is, in the present embodiment, a dual-gate transistor in which an N-type oxide semiconductor is used is exemplified as the transistor 120. However, the transistor 120 may be a bottom-gate transistor in which only the gate electrode 128 is arranged, or may be a top-gate transistor in which only the gate electrode 123 is arranged.

Openings 127d and 127e that reach each of the source region 121d and the drain region 121e of the oxide semiconductor layer 121 are arranged in the gate insulating layer 122 and the interlayer insulating layer 126. Metal nitride layers 124c and 124d are arranged inside the opening 127d, inside the opening 127e, and on the source region 121d and the drain region 121e. The metal nitride layers 124c and 124d are in contact with an upper surface of the oxide semiconductor layer 121 and the upper surface of the interlayer insulating layer 126. The source electrode 125c and the drain electrode 125d are arranged inside the opening 127d, inside the opening 127e, and on the metal nitride layers 124c and 124d.

With regards to the above configuration, the gate electrode 123 may be referred to as a "first gate electrode", the gate insulating layer 122 may be referred to as a "first gate insulating layer", the gate electrode 128 may be referred to as a "second gate electrode", and the gate insulating layer 129 may be referred to as a "second gate insulating layer". The source electrode 125c and the drain electrode 125d may be simply referred to as "electrodes". Similarly, an interlayer insulating layer 116 may simply be referred to as an "insulating layer." On the other hand, unlike the above, the gate electrode 123 may be referred to as a "second gate electrode", the gate insulating layer 122 may be referred to as a "second gate insulating layer", the gate electrode 128 may be referred to as a "first gate electrode", and the gate insulating layer 129 may be referred to as a "first gate insulating layer".

When expressed as described above, a configuration of the semiconductor device 100 can be paraphrased as follows. The first gate electrode (the gate electrode 123) faces the oxide semiconductor layer 121. The first gate insulating layer (the gate insulating layer 122) is present between the oxide semiconductor layer 121 and the first gate electrode (the gate electrode 123). The electrodes (the source electrode 125c and the drain electrode 125d) are arranged in a region overlapping the oxide semiconductor layer 121 in a plan view and electrically connected to the oxide semiconductor layer 121. The metal nitride layers 124c and 124d are present between the oxide semiconductor layer 121 and the electrodes (the source electrode 125c and the drain electrode 125d).

Similarly, the configuration of the semiconductor device 100 can be rephrased as follows. The metal nitride layers 124c and 124d are in contact with the oxide semiconductor layer 121. The second gate electrode (the gate electrode 128) faces the oxide semiconductor layer 121 below the oxide semiconductor layer 121. The second gate insulating layer (the gate insulating layer 129) is present between the oxide semiconductor layer 121 and the second gate electrode (the gate electrode 128). The openings 127d and 127e are arranged in each of the second gate insulating layer (the gate insulating layer 129) and the insulating layer (the interlayer insulating layer 116). The metal nitride layers 124c and 124d are arranged inside the openings 127d and 127e and on the insulating layer (the interlayer insulating layer 116) and are in contact with the oxide semiconductor layer 121 at a bottom part of the openings 127d and 127e.

Conventionally, in the case where a transistor in which an oxide semiconductor is used is formed, the following problem has arisen. In the case where the conductive layer in contact with the oxide semiconductor is processed into a desired shape, a surface of the oxide semiconductor may be damaged. The oxide semiconductor of the damaged region contains many oxygen vacancies. When an oxygen vacancy occurs in the oxide semiconductor, the off-leakage current of the transistor increases. In order to solve this problem, it is necessary to introduce a sufficient amount of oxygen into the oxide semiconductor by a heat treatment. However, this heat treatment causes the source electrode and the drain electrode to react with the oxide semiconductor, thereby reducing the on-state current of the transistor. Therefore, in an embodiment of the present invention, the metal nitride layer is arranged between the oxide semiconductor layer and the source electrode and between the oxide semiconductor layer and the drain electrode. The metal nitride layer suppresses the reaction between the oxide semiconductor and the electrode due to the heat treatment.

### [1-2. Material of Each Member of Semiconductor Device 100]

A rigid substrate having light transmittance such as a glass substrate, a quartz substrate, a sapphire substrate, or the like, is used as the substrate 101. In the case where the substrate 101 needs to have flexibility, a substrate containing a resin such as a polyimide substrate, an acryl substrate, a siloxane substrate, or a fluororesin substrate is used as the substrate 101. In the case where the substrate containing a resin is used as the substrate 101, an impurity may be introduced into the resin in order to improve the heat resistance of the substrate 101. In particular, in the case where the semiconductor device 100 is a top-emission display, the substrate 101 does not need to be transparent, so that an impurity that degrades the transparency of the substrate 101 may be used. In the case where the semiconductor device 100 is used in an integrated circuit other than a display device, a semiconductor substrate such as a silicon substrate, a silicon carbide substrate, and a compound semiconductor substrate, or a substrate that does not have light transmittance such as a conductive substrate such as a stainless substrate is used as the substrate 101.

A common metal material is used as the conductive layer including the wiring 119, the gate electrodes 123, and 128, the source electrode 125c, and the drain electrode 125d. For example, aluminum (Al), titanium (Ti), chromium (Cr), cobalt (Co), nickel (Ni), molybdenum (Mo), hafnium (Hf), tantalum (Ta), tungsten (W), bismuth (Bi), silver (Ag), copper (Cu), and an alloy or compound thereof can be used. The above-described material may be used in a single layer or stacked layer as the conductive layer.

A common insulating material is used as the insulating layer including the insulating layer 112, the interlayer insulating layer 126, and the gate insulating layers 122 and 129. For example, an inorganic insulating layer such as silicon oxide (SiOₓ), silicon oxynitride (SiOₓN_{y}), aluminum oxide (AlOₓ), aluminum oxynitride (AlOₓN_{y}), silicon nitride (SiNₓ), silicon nitride oxide (SiNₓO_{y}), aluminum nitride (AlNₓ), and aluminum nitride oxide (AlNₓO_{y}) is used as the insulating layer. The above-described material may be used in a single layer or stacked layer as the insulating layer.

An insulating layer having a function of releasing oxygen by a heat treatment is used as the interlayer insulating layer 126. That is, an oxide insulating layer excessively containing oxygen is used as the interlayer insulating layer 126. For example, the temperature of the heat treatment in which the interlayer insulating layer 126 releases oxygen is 600°C or lower, 500°C or lower, 450°C or lower, or 400°C or lower. That is, for example, the interlayer insulating layer 126 releases oxygen at a heat treatment temperature performed in the manufacturing process of the semiconductor device 100 in the case where a glass substrate is used as the substrate 101.

An insulating layer with few defects is used as the gate insulating layers 122 and 129. For example, in the case where a composition ratio of oxygen in the gate insulating layers 122 and 129 and a composition ratio of oxygen in the insulating layer (hereinafter referred to as "other insulating layer") having the same composition as the gate insulating layers 122 and 129 are compared, the composition ratio of oxygen in the gate insulating layers 122 and 129 is closer to the stoichiometric ratio with respect to the insulating layer than the composition ratio of oxygen in the other insulating layer. Specifically, in the case where silicon oxide (SiOₓ) is used for each of the gate insulating layers 122 and 129 and the interlayer insulating layer 126, the composition ratio of oxygen in the silicon oxide used as the gate insulating layers 122 and 129 is closer to the stoichiometric ratio of silicon oxide as compared with the composition ratio of oxygen in the silicon oxide used as the interlayer insulating layer 126. For example, a layer in which no defects are observed when evaluated by an electron-spin resonance method (ESR) may be used as the gate insulating layers 122 and 129.

SiOₓN_{y} and AlOₓN_{y} are a silicon compound and aluminum compound containing a smaller proportion (x > y) of nitrogen (N) than oxygen (O). SiNₓO_{y} and AlNₓO_{y} are a silicon compound and aluminum compound containing a smaller proportion (x > y) of oxygen than nitrogen.

A metal oxide having semiconducting properties may be used as the oxide semiconductor layer 121. For example, an oxide semiconductor containing indium (In), gallium (Ga), zinc (Zn), and oxygen (O) may be used as the oxide semiconductor layer 121. For example, an oxide semiconductor having a composition ratio of In : Ga : Zn : O = 1 : 1 : 1 : 4 may be used as the oxide semiconductor layer 121. However, the oxide semiconductor containing In, Ga, Zn and O used in the present embodiment is not limited to the above-described composition. An oxide semiconductor having a composition other than the above may be used as the oxide semiconductor. For example, an oxide semiconductor layer having a higher ratio of In than those described above may be used to improve mobility. On the other hand, in order to increase a bandgap and reduce the influence of light irradiation, an oxide semiconductor layer having a larger ratio of Ga than those described above may be used.

An oxide semiconductor containing two or more metals including indium (In) may be used as the oxide semiconductor layer 121. In this case, in the oxide semiconductor layer 121, the ratio of the indium element to the total amount of metal elements may be 50% or more in atomic ratio. Gallium (Ga), zinc (Zn), aluminum (Al), hafnium (Hf), yttrium (Y), zirconia (Zr), and lanthanoids may be used as the oxide semiconductor layer 121 in addition to indium. Elements other than those described above may be used as the oxide semiconductor layer 121.

Other elements may be added to the oxide semiconductor containing In, Ga, Zn, and O as the oxide semiconductor layer 121, and metal elements such as Al and Sn may be added. In addition to the above oxide semiconductor, an oxide semiconductor (IGO) containing In and Ga, an oxide semiconductor (IZO) containing In and Zn, an oxide semiconductor (ITZO) containing In, Sn, and Zn, and an oxide semiconductor containing In and W may be used as the oxide semiconductor layer 121.

In the case where the ratio of the indium element is large, the oxide semiconductor layer 121 is likely to crystallize. As described above, the oxide semiconductor layer 121 having a polycrystalline structure can be obtained by using a material in which the ratio of the indium element to the total amount of metal elements is 50% or more. The oxide semiconductor layer 121 preferably contains gallium as a metal element other than indium. Gallium belongs to the same Group 13 element as indium. Therefore, the crystallinity of the oxide semiconductor layer 121 is not inhibited by gallium, and the oxide semiconductor layer 121 has a polycrystalline structure.

Although a detailed method for manufacturing the oxide semiconductor layer 121 will be described later, the oxide semiconductor layer 121 can be formed using a sputtering method. A composition of the oxide semiconductor layer 121 formed by the sputtering method depends on a composition of a sputtering target. Even when the oxide semiconductor layer 121 has a polycrystalline structure, the composition of the sputtering target substantially matches the composition of the oxide semiconductor layer 121. In this case, A composition of the metal element of the oxide semiconductor layer 121 can be specified based on a composition of the metal element of the sputtering target.

In the case where the oxide semiconductor layer 121 has a polycrystalline structure, the composition of the oxide semiconductor layer may be identified using an X-ray diffraction (XRD) method. Specifically, the composition of the metal element of the oxide semiconductor layer can be specified based on the crystalline structure and the lattice constant of the oxide semiconductor layer obtained by the XRD method. Furthermore, the composition of the metal element of the oxide semiconductor layer 121 can also be identified using a fluorescent X-ray analysis, or Electron Probe Micro Analyzer: EPMA analysis, or the like. However, the oxygen element contained in the oxide semiconductor layer 121 may not be identified by these methods because the oxygen element varies depending on the sputtering process conditions.

As described above, the oxide semiconductor layer 121 may include an amorphous structure and may include a polycrystalline structure. The oxide semiconductor having a polycrystalline structure can be manufactured using a Poly-OS (Poly-crystalline Oxide Semiconductor) technique described below. In the following explanation, when distinguishing from the oxide semiconductor having an amorphous structure, the oxide semiconductor having a polycrystalline structure may be described as the Poly-OS.

A metal oxide layer may be arranged between the gate insulating layer 129 and the oxide semiconductor layer 121. In this case, the metal oxide layer may be in contact with the oxide semiconductor layer 121. A metal oxide containing aluminum as a main component is used as the metal oxide layer. For example, an inorganic insulating layer such as aluminum oxide (AlOₓ), aluminum oxynitride (AlOₓN_{y}), and aluminum oxynitride (AlNₓO_{y}) are used as the metal oxide layer. The "metal oxide layer containing aluminum as a main component" means that the proportion of aluminum contained in the metal oxide layer is 1% or more of the entire metal oxide layer. The proportion of aluminum contained in the metal oxide layer may be 5% or more and 70% or less, 10% or more and 60% or less, or 30% or more and 50% or less of the entire metal oxide layer. The ratio may be a mass ratio or a weight ratio.

A nitride of a common metal material is used as the metal nitride layers 124c and 124d. For example, titanium nitride, molybdenum nitride, tungsten nitride, and tantalum nitride are used as the metal nitride layers 124c and 124d. The metal nitride layers 124c and 124d contain the same metal elements as the metal element contained in the source electrode 125c and the drain electrode 125d. For example, in the case where the structure of the source electrode 125c and the drain electrode 125d is Al/Ti (upper layer/lower layer), the metal nitride layers 124c and 124d may be titanium nitride.

In this case, the lower layer (Ti) included in the source electrode 125c and the drain electrode 125d (electrode) may be referred to as a "first conductive layer", and the upper layer (Al) thereof may be referred to as a "second conductive layer". When expressed as described above, the configuration of the semiconductor device 100 can be paraphrased as follows. The electrodes (the source electrode 125c and the drain electrode 125d) include the first conductive layer (Ti) and the second conductive layer (Al) on the first conductive layer (Ti). The first conductive layer (Ti) is in contact with the metal nitride layers 124c and 124d. The metal nitride layers 124c and 124d (for example, TiN) contain the same metal element as the metal element contained in the first conductive layer (Ti).

### [1-3. Poly-OS Technique]

The Poly-OS contained in the oxide semiconductor layer is formed using sputtering and a heat treatment. Here, a method for forming the oxide semiconductor layer will be described.

First, the oxide semiconductor layer is deposited by sputtering. The deposited oxide semiconductor layer has an amorphous structure. In this case, the amorphous structure means a structure in which a long-range ordered structure does not exist and a periodic crystal lattice arrangement is not observed. For example, when the oxide semiconductor layer having an amorphous structure is observed using the XRD method, a certain peak based on the crystalline structure cannot be obtained in the diffractive pattern. The oxide semiconductor layer having an amorphous structure may have a short-range ordered structure in a micro region. However, such an oxide semiconductor layer does not exhibit characteristics of the Poly-OS and can therefore be classified as an oxide semiconductor layer having an amorphous structure.

In the Poly-OS techniques, the oxide semiconductor layer is deposited at a low temperature. For example, a temperature of a substrate on which the oxide semiconductor layer is deposited is 150°C or lower, preferably 100°C or lower, and more preferably 50°C or lower. When the temperature of the substrate is high during the deposition of the oxide semiconductor layer, microcrystals are likely to be generated in the oxide semiconductor to be deposited. The oxygen partial pressure in a chamber during deposition is 1% or more and 10% or less, preferably 1% or more and 5% or less, and more preferably 2% or more and 4% or less. When the oxygen partial pressure is high, microcrystals are generated in the oxide semiconductor layer due to excess oxygen contained in the oxide semiconductor. On the other hand, under the condition where the oxygen partial pressure is less than 1%, the composition of oxygen in the oxide semiconductor layer becomes uneven, and an oxide semiconductor layer containing a large amount of microcrystals or an oxide semiconductor layer which does not crystallize even when subjected to a heat treatment is formed.

Next, a heat treatment is performed on the oxide semiconductor layer deposited by sputtering. The heat treatment is performed in the atmosphere, but the atmosphere of the heat treatment is not limited to this. The temperature of the heat treatment is 300°C or higher and 500°C or lower, preferably 350°C or higher and 450°C or lower. The time of the heat treatment is 15 minutes or more and 120 minutes or less, preferably 30 minutes or more and 60 minutes or less. By performing the heat treatment, the oxide semiconductor layer having an amorphous structure is crystallized to form the oxide semiconductor layer containing the Poly-OS.

### [1-4. Characteristics of Oxide Semiconductor Layer 121]

Next, the characteristics of the oxide semiconductor layer used as the oxide semiconductor layer 121 and containing the Poly-OS will be described below.

The oxide semiconductor layer has excellent etching resistance. Specifically, the oxide semiconductor layer has a very low etching rate when etching using an etchant during wet etching. This means that the oxide semiconductor layer is hardly etched by the etchant. When the oxide semiconductor layer is etched at about 40°C using an etchant containing phosphoric acid as a main component, the etching rate is less than 3 nm/min, less than 2 nm/min, or less than 1 nm/min. The proportion of phosphoric acid in the etchant is 50% or more, 60% or more, or 70% or more. The etchant may contain nitric acid and acetic acid in addition to phosphoric acid. The temperature of about 40°C is a set temperature of a device holding the etchant, and the actual temperature of the etchant is 35°C or higher and 45°C or lower.

On the other hand, in the case where the oxide semiconductor layer is etched using the etchant containing phosphoric acid as a main component at a temperature of about 40°C with respect to an oxide semiconductor layer containing no Poly-OS, for example, the oxide semiconductor layer having an amorphous structure before the heat treatment, the etching rate is 100 nm/min or more.

In the case where the oxide semiconductor layer containing the Poly-OS is etched using 0.5% of a hydrofluoric acid solution at room temperature (for example, about 22°C), the etching rate is less than 5 nm/min, less than 4 nm/min, or less than 3 nm/min. In this case, the room temperature is 25°C±5°C. The actual temperature of the etchant at this time is 20°C or higher and 30°C or lower.

On the other hand, in the case where the oxide semiconductor layer containing no Poly-OS is etched using 0.5% of the hydrofluoric acid solution at room temperature, the etching rate is 15 nm/min or more.

Here, an embodiment of the oxide semiconductor layer is shown in Table 1. Table 1 shows the etching rates for a mixed acid etching solution and 0.5% of the hydrofluoric acid solution for each of the prepared samples. "Mixed acid AT-2F (product name)" manufactured by Rasa Industries, Ltd. was used as the mixed acid etching solution. The proportion of phosphoric acid in the mixed acid etching solution is about 65%. When each sample was etched, the temperature of the mixed acid etching solution was about 40°C and the temperature of 0.5% of the hydrofluoric acid solution was room temperature. In Table 1, Sample 1 is the oxide semiconductor layer containing the Poly-OS, Sample 2 is the oxide semiconductor layer having an amorphous structure before the heat treatment, and Sample 3 is an oxide semiconductor layer containing indium gallium zinc oxide (IGZO) with an indium ratio of less than 50%.

**[Table 1]**

| | Mixed acid etching solution | 0.5% hydrofluoric acid solution |
|---|---|---|
| Sample 1 | < 0. 1 nm/min | < 2 nm/min |
| Sample 2 | 111 nm/min | > 18 nm/min |
| Sample 3 | 162 nm/min | - |

As shown in Table 1, Sample 1 (the oxide semiconductor layer containing the Poly-OS) is hardly etched by the mixed acid etching solution, and only 2 nm/min is etched using 0.5% of the hydrofluoric acid solution. With respect to the mixed acid etching solution, the etching rate of Sample 1 is 1/100 or less of the etching rate of Sample 2 (the oxide semiconductor layer having an amorphous structure before the heat treatment). With respect to 0.5% of the hydrofluoric acid solution, the etching rate of Sample 1 is about 1/10 or less of the etching rate of Sample 2. With respect to the mixed acid etching solution, the etching rate of Sample 1 is 1/100 or less of the etching rate of Sample 3 (the oxide semiconductor layer containing IGZO with an indium ratio of less than 50%). That is, Sample 1 has significantly better etching resistance than Sample 2 and Sample 3.

Such excellent etching resistance of the oxide semiconductor layer containing Poly-OS is a property that cannot be obtained in the oxide semiconductor having a polycrystalline structure manufactured by the conventional process at 500°C or lower. Although the detailed mechanism for the excellent etching resistance of the oxide semiconductor layer containing the Poly-OS is unclear, the Poly-OS is considered to have a polycrystalline structure different from that of the conventional one.

As discussed above, the etching rate of the oxide semiconductor layer containing the Poly-OS to the etchant is very low. Therefore, it is very difficult to pattern the oxide semiconductor layer. Therefore, in the case where an island-shaped oxide semiconductor layer is formed, the oxide semiconductor layer having an amorphous structure before the heat treatment is patterned into an island shape, and thereafter, the oxide semiconductor layer patterned into the island shape is crystallized by performing the heat treatment. As a result, the island-shaped oxide semiconductor layer containing the Poly-OS is formed.

### [1-5. Method for Manufacturing Semiconductor Device 100]

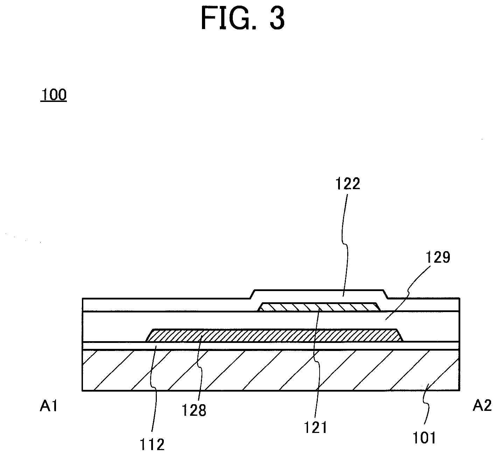

A method for manufacturing the semiconductor device according to an embodiment of the present invention will be described with reference to FIG. 3 to FIG. 6. FIG. 3 to FIG. 6 are cross-sectional views illustrating the method for manufacturing the semiconductor device according to an embodiment of the present invention.

As shown in FIG. 3, the insulating layer 112 is first formed on the substrate 101. Next, a conductive layer is formed on the insulating layer 112, the conductive layer is processed by a photolithography process, and the gate electrode 128 included in the transistor 120 is formed.

Next, the gate insulating layer 129 is formed on the gate electrode 128. Next, the oxide semiconductor layer is formed on the gate insulating layer 129, the semiconductor layer is processed by the photolithography process, and the oxide semiconductor layer 121 is formed. Next, the gate insulating layer 122 is formed on the gate insulating layer 129 and the oxide semiconductor layer 121.

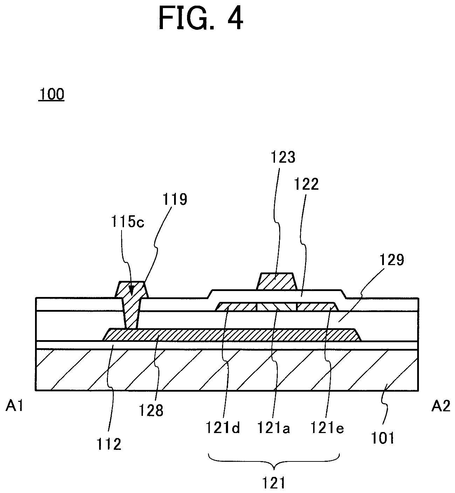

As shown in FIG. 4, the gate insulating layers 122 and 129 are processed by the photolithography process to form the opening 115c reaching the gate electrode 128. Next, a conductive layer is deposited on the gate insulating layer 122 and inside the opening 115c. The wiring 119 and the gate electrode 123 are formed by processing the deposited conductive layer by the photolithography process.

Next, using the gate electrode 123 as a mask, an impurity is implanted into the oxide semiconductor layer 121 through the gate insulating layer 122. By implanting the impurity, the channel region 121a, the source region 121d, and the drain region 121e are formed. A method of forming the source region 121d and the drain region 121e will be described later.

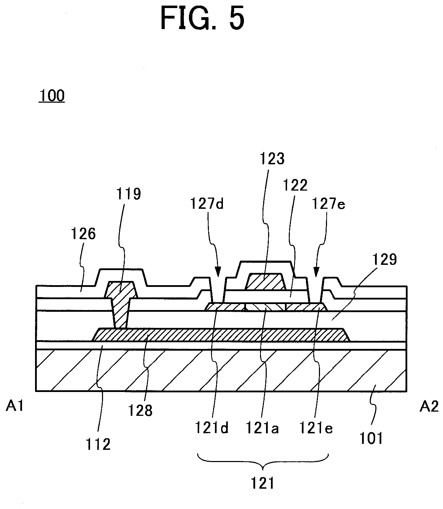

As shown in FIG. 5, the interlayer insulating layer 126 covering the wiring 119 and the gate electrode 123 is formed on the gate insulating layer 122. By processing the gate insulating layer 122 and the interlayer insulating layer 126 by the photolithography process, the openings 127d and 127e that reach the source region 121d and the drain region 121e of the oxide semiconductor layer 121 are formed.

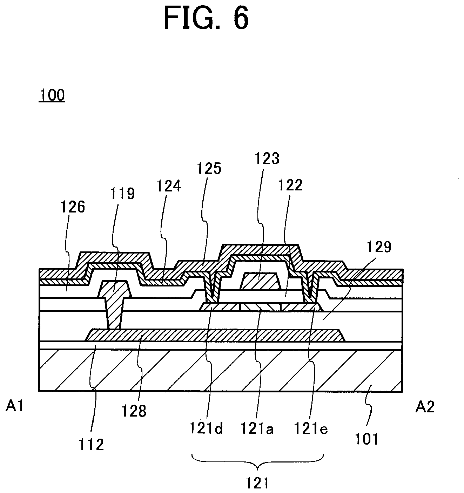

As shown in FIG. 6, the metal nitride layer 124 and a conductive layer 125 are deposited on the interlayer insulating layer 126 and inside the openings 127d and 127e. The metal nitride layers 124c and 124d, the source electrode 125c, and the drain electrode 125d shown in FIG. 2 are formed by processing the deposited metal nitride layer 124 and the conductive layer 125 by the photolithography process.

As described above, since the metal nitride layer 124c is arranged between the oxide semiconductor layer 121 and the source electrode 125c and the metal nitride layer 124d is arranged between the oxide semiconductor layer 121 and the drain electrode 125d, an increase in contact resistance can be suppressed.

### [1-6. Method of Forming Source Region 121d and Drain Region 121e]

A method of forming the source region 121d and the drain region 121e will be described with reference to FIG. 4. As shown in FIG. 4, ion implantation is performed on the oxide semiconductor layer 121 in a state where the gate insulating layer 122 and the gate electrode 123 are formed on the oxide semiconductor layer 121. For example, boron (B) is implanted as an impurity element into the oxide semiconductor layer 121 by ion implantation. However, other impurity elements such as phosphorus (P) may be implanted into the oxide semiconductor layer 121 instead of boron.

In a region (the source region 121d and the drain region 121e) where the gate electrode 123 is not arranged, the impurity element passes through the gate insulating layer 122 and reaches the oxide semiconductor layer 121. However, since the impurity element is blocked by the gate electrode 123 in a region (the channel region 121a) where the gate electrode 123 is arranged, the impurity element does not reach the oxide semiconductor layer 121.

By the ion implantation described above, the source region 121d and the drain region 121e in which the impurity element is implanted are formed in the oxide semiconductor layer 121. In the oxide semiconductor layer 121 in the source region 121d and the drain region 121e, oxygen defects are formed by the implantation of the impurity element. Therefore, the resistance of the oxide semiconductor layer 121 in the source region 121d and the drain region 121e is reduced. In the oxide semiconductor layer 121 containing the Poly-OS, the source region 121d and the drain region 121e in which the impurity element is implanted may have crystallinity. This is also one of the characteristics of the Poly-OS. The crystal structure of each of the source region 121d and the drain region 121e is the same as the crystal structure of the channel region 121a.

### [2. Second Embodiment]

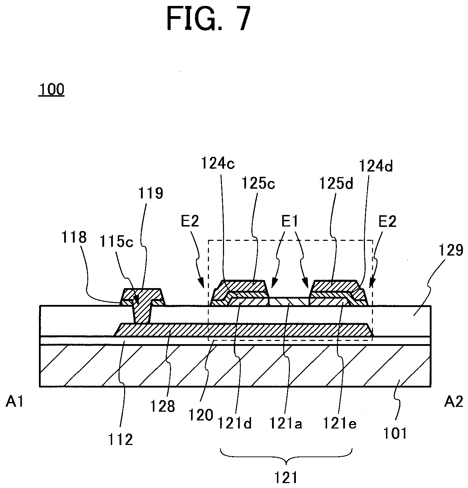

An example of a structure of the semiconductor device 100 according to an embodiment of the present invention will be described with reference to FIG. 7 to FIG. 10.

### [2-1. Configuration of Semiconductor Device]

FIG. 7 is a cross-sectional view when the semiconductor device 100 is cut along a line A1-A2 similar to FIG. 1. As shown in FIG. 1 and FIG. 7, the semiconductor device 100 according to an embodiment of the present invention includes the transistor 120 arranged on the substrate 101.

As shown in FIG. 7, a metal nitride layer 118 is arranged on the gate insulating layer 129. The wiring 119 is arranged on the metal nitride layer 118. The wiring 119 is connected to the gate electrode 128 via the opening 115c arranged in the gate insulating layer 129. The metal nitride layer 118 is formed only on an upper surface of the gate insulating layer 129, and is not formed on the side walls of the opening 115c and an upper surface of the gate electrode 128.

As shown in FIG. 7, the oxide semiconductor layer 121 is arranged on the gate insulating layer 129. The metal nitride layers 124c and 124d are in contact with the upper surface and the side surface of the oxide semiconductor layer 121. The source electrode 125c and the drain electrode 125d are arranged on the upper surface of the metal nitride layers 124c and 124d.

The source electrode 125c and the metal nitride layer 124c are arranged in a region including the source region 121d. The drain electrode 125d and the metal nitride layer 124d are arranged in a region including the drain region 121e. The metal nitride layers 124c and 124d, the source electrode 125c, and the drain electrode 125d are not arranged in the channel region 121a. In other words, the oxide semiconductor layer 121 in the channel region 121a is exposed from the metal nitride layer and the conductive layer formed on the oxide semiconductor layer 121.

In the transistor 120 shown in FIG. 7, a voltage for controlling the channel region 121a is supplied to the gate electrode 128. That is, the transistor 120 is a bottom-gate transistor.

As described above, the oxide semiconductor layer 121 has the channel region 121a, the source region 121d, and the drain region 121e. In a cross-sectional view that is cut along a line (a line connecting A1 and A2) extending in the channel length direction from the source region 121d to the drain region 121e, edges (E1) of the metal nitride layers 124c and 124d and the electrodes (the source electrode 125c and the drain electrode 125d) closer to the channel region 121a are matched. Similarly, in the cross-sectional view, edges (E2) of the metal nitride layers 124c and 124d and the electrodes (the source electrode 125c and the drain electrode 125d) farther from the channel region 121a are matched.

### [2-2. Method for Manufacturing Semiconductor Device 100]

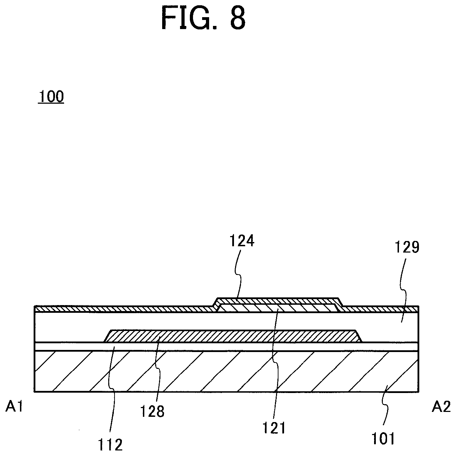

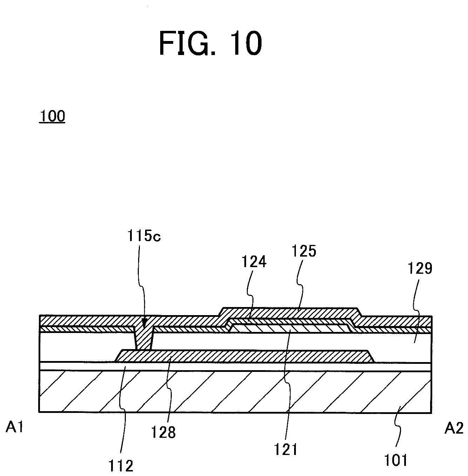

FIG. 10 is a cross-sectional view of a semiconductor device according to an embodiment of the present invention. FIG. 8 to FIG. 10 are cross-sectional views illustrating a method for manufacturing a semiconductor device according to an embodiment of the present invention.

Since the manufacturing method shown in FIG. 8 is the same as the manufacturing method shown in FIG. 3 up to the step of forming the oxide semiconductor layer 121, the explanation thereof will be omitted. As shown in FIG. 8, after the oxide semiconductor layer 121 is formed, the metal nitride layer 124 is deposited on the gate insulating layer 129 and on the oxide semiconductor layer 121.

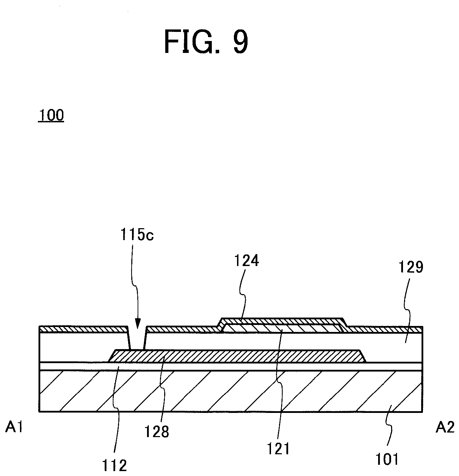

As shown in FIG. 9, the deposited metal nitride layers 124, the insulating layer 112, and the gate insulating layer 129 are processed by the photolithography process to form the opening 115c reaching the gate electrode 128.

As shown in FIG. 10, the conductive layer 125 is deposited on the metal nitride layers 124 and inside the opening 115c. By processing the deposited conductive layer 125 by the photolithography process, the metal nitride layers 124c, 124d, and 118, the source electrode 125c, the drain electrode 125d, and the wiring 119 shown in FIG. 7 are formed.

As described above, since the metal nitride layer 124c is arranged between the oxide semiconductor layer 121 and the source electrode 125c and the metal nitride layer 124d is arranged between the oxide semiconductor layer 121 and the drain electrode 125d, an increase in contact resistance can be suppressed.

### [3. Third Embodiment]

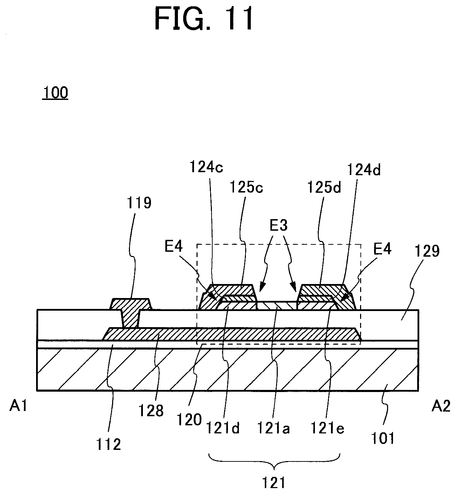

An example of a structure of the semiconductor device 100 according to an embodiment of the present invention will be described with reference to FIG. 11 to FIG. 14.

### [3-1. Configuration of Semiconductor Device]

FIG. 11 is a cross-sectional view when the semiconductor device 100 is cut along a line A1-A2 similar to FIG. 1. As shown in FIG. 1 and FIG. 11, the semiconductor device 100 according to an embodiment of the present invention includes the transistor 120 arranged on the substrate 101.

Although a configuration of the transistor 120 shown in FIG. 11 is similar to the configuration of each of the transistors 120 shown in FIG. 7, the configurations are different from each other in the region where the metal nitride layers are arranged.

In the transistor 120 shown in FIG. 7, the metal nitride layer 118 is arranged between the wiring 119 and the gate insulating layer 129, but in the transistor 120 shown in FIG. 11, the metal nitride layer is not arranged in the same position as described above. That is, the wiring 119 is in contact with the upper surface of the gate insulating layer 129.

Similarly, in the transistor 120 shown in FIG. 7, the metal nitride layers 124c and 124d are formed from the upper surface of the oxide semiconductor layer 121 to the upper surface of the gate insulating layer 129 beyond the side surface of the oxide semiconductor layer 121, but in the transistor 120 shown in FIG. 11, the metal nitride layers 124c and 124d are formed only on the upper surface of the oxide semiconductor layer 121. That is, the metal nitride layers 124c and 124d are not formed on the side surface of the oxide semiconductor layer 121. The side surface of the oxide semiconductor layer 121 is in contact with the source electrode 125c and the drain electrode 125d arranged above the metal nitride layers 124c and 124d.

As described above, the oxide semiconductor layer 121 has the channel region 121a, the source region 121d, and the drain region 121e. In a cross-sectional view cut along a line (a line connecting A1 and A2) extending in the channel length direction from the source region 121d to the drain region 121e, edges (E3) of the metal nitride layer 124c and the electrodes (the source electrode 125c and the drain electrode 125d) closer to the channel region 121a are matched. Similarly, in the cross-sectional view, edges (E4) of the metal nitride layer 124c and the oxide semiconductor layer 121 farther from the channel region 121a are matched.

### [3-2. Method for Manufacturing Semiconductor Device 100]

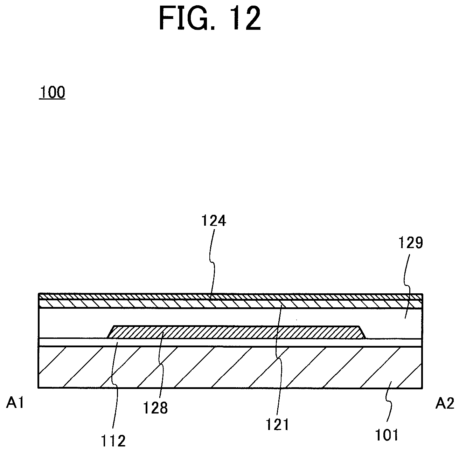

A method for manufacturing a semiconductor device according to an embodiment of the present invention will be described with reference to FIG. 12 to FIG. 14. FIG. 12 to FIG. 14 are cross-sectional views illustrating a method for manufacturing a semiconductor device according to an embodiment of the present invention.

Since the manufacturing method shown in FIG. 12 is the same as the manufacturing method shown in FIG. 3 up to the step of forming the gate insulating layer 129, the explanation thereof will be omitted. After the gate insulating layer 129 is formed, the oxide semiconductor layer 121 and the metal nitride layer 124 are deposited on the gate insulating layer 129.

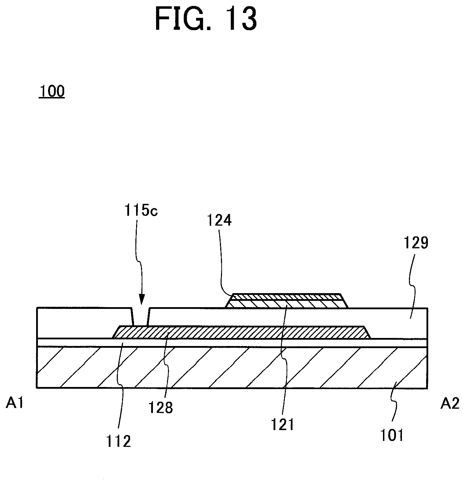

As shown in FIG. 13, the formed oxide semiconductor layer 121 and the metal nitride layer 124 are processed by a photolithography process. Next, the gate insulating layer 129 is processed by the photolithography process to form the opening 115c reaching the gate electrode 128.

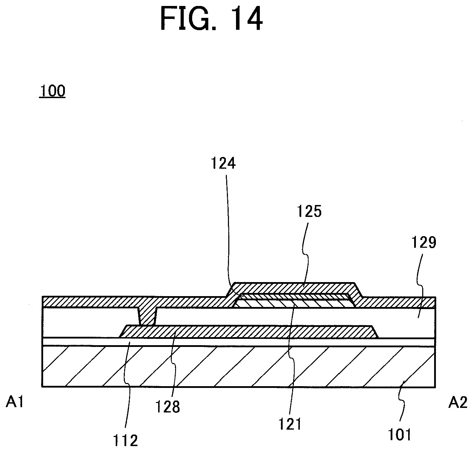

As shown in FIG. 14, the conductive layer 125 is deposited on the metal nitride layers 124 and inside the opening 115c. The deposited conductive layer 125 is processed by the photolithography process to form the metal nitride layers 124c and 124d, the source electrode 125c, the drain electrode 125d, and the wiring 119 shown in FIG. 11.

As described above, since the metal nitride layer 124c is arranged between the oxide semiconductor layer 121 and the source electrode 125c and the metal nitride layer 124d is arranged between the oxide semiconductor layer 121 and the drain electrode 125d, an increase in contact resistance can be suppressed.

### [4. Fourth embodiment]

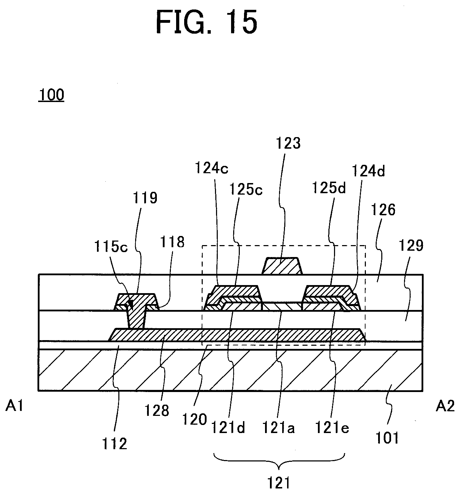

An example of a structure of the semiconductor device 100 according to an embodiment of the present invention will be described with reference to FIG. 15.

### [4-1. Configuration of Semiconductor Device]

FIG. 15 is a cross-sectional view when the semiconductor device 100 is cut along a line A1-A2 similar to FIG. 1. As shown in FIG. 1 and FIG. 15, the semiconductor device 100 according to an embodiment of the present invention includes the transistor 120 arranged on the substrate 101.

A configuration of the transistor 120 shown in FIG. 15 is similar to the configuration of each of the transistors 120 shown in FIG. 7, but is different from the transistor 120 shown in FIG. 7 in that the gate electrode 123 is arranged above the oxide semiconductor layer 121. In the transistor 120 shown in FIG. 15, a voltage for controlling the channel region 121a is supplied to the gate electrodes 123 and 128. That is, the transistor 120 is a dual-gate transistor. In the transistor 120, the voltage for controlling the channel region 121a may not be supplied to the gate electrode 128, and a predetermined fixed voltage may be supplied to the gate electrode 128. The gate electrode 128 may be floating. The transistor 120 may be a top-gate transistor in which the gate electrode 128 is omitted and the voltage for controlling the channel region 121a is supplied to the gate electrode 123.

The transistor 120 shown in FIG. 15 is obtained by forming the interlayer insulating layer 126 on the transistor 120 shown in FIG. 7, forming the conductive layer on the interlayer insulating layer 126, and processing the conductive layer into the gate electrode 123 by the photolithography process. The interlayer insulating layer 126 functions as the gate insulating layer.

Even in the semiconductor device 100 according to the present embodiment, the same advantages as those of the other embodiments described above can be obtained.

Each of the embodiments described above as an embodiment of the present invention can be appropriately combined and implemented as long as no contradiction is caused. Furthermore, the addition, deletion, or design change of components, or the addition, deletion, or condition change of processes as appropriate by those skilled in the art based on each embodiment are also included in the scope of the present invention as long as they are provided with the gist of the present invention.

Furthermore, it is understood that, even if the effect is different from those provided by each of the above-described embodiments, the effect obvious from the description in the specification or easily predicted by persons ordinarily skilled in the art is apparently derived from the present invention.

### REFERENCES SIGNS LIST

100: semiconductor device, 101: substrate, 112: insulating layer, 115c: opening, 116: interlayer insulating layer, 118: metal nitride layer, 119: wiring, 120: transistor, 121: oxide semiconductor layer, 121a: channel region, 121d: source region, 121e: drain region, 122, 129: gate insulating layers, 123, 128: gate electrode, 124: metal nitride layer, 125: conductive layer, 125c: source electrode, 125d: drain electrode, 126: interlayer insulating layer, 127d, 127e: opening, E1-E4: edge

## Claims

1. A semiconductor device comprising:
an oxide semiconductor layer;
a first gate electrode facing the oxide semiconductor layer;
a first gate insulating layer between the oxide semiconductor layer and the first gate electrode;
an electrode arranged in a region overlapping the oxide semiconductor layer in a plan view and electrically connected to the oxide semiconductor layer; and
a metal nitride layer between the oxide semiconductor layer and the electrode,
wherein
the oxide semiconductor layer is polycrystalline, and
an etching rate of the oxide semiconductor layer with respect to an etchant containing phosphoric acid as a main component is less than 3 nm/min at 40°C.

2. The semiconductor device according to claim 1, wherein the metal nitride layer contains the same metal element as a metal element included in the electrode.

3. The semiconductor device according to at least one of the previous claims, wherein
the electrode includes a first conductive layer and a second conductive layer above the first conductive layer,
the first conductive layer is in contact with the metal nitride layer, and
the metal nitride layer contains the same metal element as a metal element included in the first conductive layer.

4. The semiconductor device according to at least one of the previous claims, wherein the metal nitride layer is in contact with the oxide semiconductor.

5. The semiconductor device according to at least one of the previous claims, further comprising:
a second gate electrode facing the oxide semiconductor layer below the oxide semiconductor layer; and
a second gate insulating layer between the oxide semiconductor layer and the second gate electrode,
wherein the first gate electrode is arranged above the oxide semiconductor layer.

6. The semiconductor device according to at least one of the previous claims, further comprising an insulating layer covering the first gate electrode,
wherein
each of the gate insulating layer and the insulating layer has an opening, and
the metal nitride layer is arranged inside the opening and above the insulating layer, and is in contact with the oxide semiconductor layer at a bottom part of the opening.

7. The semiconductor device according to at least one of the previous claims, wherein the metal nitride layer is in contact with an upper surface and a side surface of the oxide semiconductor layer.

8. The semiconductor device according to at least one of the previous claims, wherein
the oxide semiconductor layer includes a channel region, a source region, and a drain region, and
in a cross sectional view cut along a line extending in a channel length direction from the source region to the drain region,
an edge of the metal nitride layer closer to the channel region and an edge of the electrode are matched, and
an edge of the metal nitride layer farther from the channel region and an edge of the electrode are matched.

9. The semiconductor device according to at least one of the previous claims, wherein
the oxide semiconductor layer includes a channel region, a source region, and a drain region, and
in a cross sectional view cut along a line extending in a channel length direction from the source region to the drain region,
an edge of the metal nitride layer closer to the channel region and an edge of the electrode are matched, and
an edge of the metal nitride layer farther from the channel region and an edge of the oxide semiconductor layer are matched.
